# EUROPEAN PATENT APPLICATION

(11) **EP 1 768 244 A1**
(43) Date of publication of application: **28.03.2007**
(21) Application number: 05755705.0
(22) Date of filing: 29.06.2005
(51) Int. Cl.: H02M 7/48, H02H 7/12, H02M 7/537

(54) **SNUBBER CIRCUIT AND POWER SEMICONDUCTOR DEVICE HAVING SNUBBER CIRCUIT**

(30) Priority: 01.07.2004 JP 2004196014
(71) Applicant: THE KANSAI ELECTRIC POWER CO., INC., Osaka-shi, Osaka 530-8270 (JP)
(72) Inventor: ASANO, K., THE KANSAI ELECTRIC POWER CO., INC., Osaka-shi, Osaka 5308270 (JP); SUGAWARA, Y., THE KANSAI ELECTRIC POWER CO., INC., Osaka-shi, Osaka 5308270 (JP)
(74) Representative: Suckling, Andrew Michael
(86) International application number: PCT/JP2005/011951
(87) International publication number: WO 2006/003936

(57) **Abstract**

A snubber circuit as a conventional protection circuit for inverters, which is composed of an anode reactor, a Si diode and a resistance, needs to keep junction temperature of the Si diode at 125 °C or lower during operation and therefore requires mounting of a large-size heat sink, which causes a large number of component parts and difficulty in downsizing. As a diode of a snubber circuit for circulating electomagnetic energy of the anode reactor, a wide gap semiconductor (SiC) diode, which does not need a heat sink or requires only a small-size heat sink, is used. When the current density of SiC diode is made 20 to 30 times larger than the current density during normal temperature operation, ON resistance increases, and therefore it becomes possible to substitute the ON resistance for the resistance of the snubber circuit. The increase in current density increases the temperature of the SiC diode. However, since the SiC diode can operate at temperature near 300 °C without any problems, a large-size heat sink is not necessary.

## Description

### TECHNICAL FIELD

The present invention relates to a snubber circuit and a power semiconductor device using a self-arc-extinguishing type semiconductor element having the snubber circuit.

### BACKGROUND ART

Self-arc-extinguishing type semiconductor elements such as gate turnoff thyristors (hereinbelow abbreviated to GTOs) are provided with a protection circuit called snubber circuit for controlling a voltage applied to between a cathode and an anode as well as steep rise of current passing the elements when the semiconductor elements are turned on and off. The snubber circuit has a function to prevent the semiconductor elements from suffering failure due to voltage, current with steep rise or over voltage applied to the semiconductor elements. The snubber circuit includes a "parallel snubber circuit" which is connected to the semiconductor elements in parallel and a "series snubber circuit" which is connected to the semiconductor elements in series. Either one of or both the parallel snubber circuit and the series snubber circuit are used according to need.

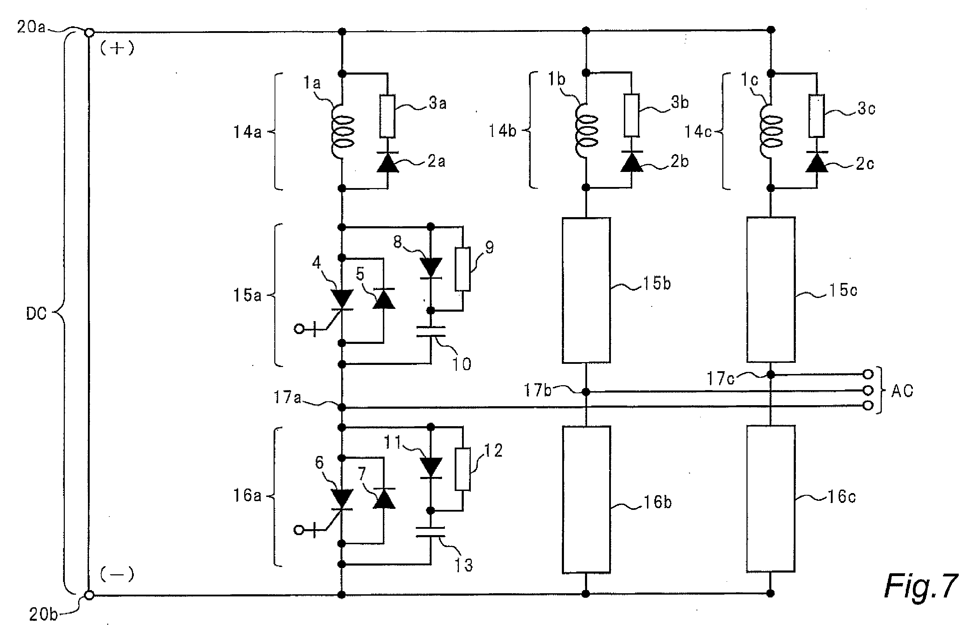

Fig. 7 is a circuit diagram showing a typical and conventional three-phase inverter device using a GTO as a switching device. In the drawing, a series connection composed of a series snubber circuit 14a, a first switching circuit 15a and a second switching circuit 16a is connected to between a positive terminal 20a and a negative terminal 20b of a direct current DC. Similarly, a series connection composed of a series snubber circuit 14b, and first and second switching circuits 15b, 16b as well as a series connection composed of a series snubber circuit 14c, and first and second switching circuits 15c, 16c are respectively connected to between the positive terminal 20a and the negative terminal 20b, by which a three-phase inverter device is structured. It is to be noted that since the first switching circuits 15b, 15c are identical to the first switching circuit 15a, and the second switching circuits 16b, 16c are identical to the second switching circuit 16a, each circuit is shown as a block to omit detailed circuit diagrams. A three-phase alternate current (AC) is outputted from a connection point 17a between the first and second switching circuits 15a and 16a, a connection point 17b between the first and second switching circuits 15b and 16b, and a connection point 17c between the first and second switching circuits 15c and 16c. Since the series snubber circuits 14a, 14b and 14c share the same structure and the same operation, detailed description will be given of the series snubber circuit 14a on behalf of the circuits. Since the first and second switching circuits 15a, 15b, 15c, 16a, 16b, 16c share the same structure and the same operation, detailed description will be given of the first switching circuit 15a (hereinbelow referred to as a switching circuit 15a) on behalf of the circuits.

The series snubber circuit 14a has a structure in which a series connection composed of a silicon semiconductor (Si) diode 2a and a resistance 3a is connected in parallel to an anode reactor 1a that is an inductor.

The switching circuit 15a has a Si GTO 4 as a switching element and a free wheeling diode 5 connected in antiparallel to between the anode and the cathode of the GTO 4. A parallel snubber circuit formed by connecting a parallel connection composed of a diode 8 and a resistance 9 in series to a capacitor 10 is further connected to between the anode and the cathode of the GTO 4. A control signal from a known control circuit which is not shown in the drawing is applied to the gate terminal of the GTO 4. With the control signal, the switching circuits 15a to 15c and 16a to 16c are turned on and off with specified timing, so that a direct current DC is converted to an alternate current and so the alternate current AC is outputted.

When the GTO 4 is turned on, a current from the direct current DC flows through the anode reactor 1a and the GTO 4. In the series snubber circuit 14a, the anode reactor 1a slows the rise of current (di/dt) generated when the GTO 4 is turned on.

When the GTO 4 is turned off, current by electromagnetic energy stored in the anode reactor 1a flows through the diode 2a and the resistance 3a and is consumed by the resistance 3a.

In the parallel snubber circuit, when the GTO 4 is turned on, the capacitor 10 discharges electric charges through the resistance 9. When the GTO 4 is turned off, the capacitor 10 is charged with electric charges by the current flowing through the diode 8. More specifically, the current, which tends to keep on flowing by the inductance of the anode reactor 1a and by the inductance of the circuit interconnections, flows into the capacitor 10 through the diode 8, so that the over voltage generated in between the anode and the cathode of the GTO 4 is suppressed. Electric charges in the capacitor 10 are gradually discharged through the resistance 9.
(Patent Document 1) JP 2000-166248 A
(Patent Document 2) JP H08-196083 A

In the conventional series snubber circuit 14a for the inverter device, the anode reactor 1a requires the diode 2a and the resistance 3a for circulation of electromagnetic energy, and this causes a problem of a relatively large number of component parts. Moreover, since the diodes 2a, 8 are silicon diodes, the junction temperature during operation needs to be kept at 125 °C or lower. Therefore, the diodes 2a, 8 are equipped with a large-size air-cooling or water-cooling heat sink for cooling with a fan and the like. Further, the diodes 2a, 8 are designed to be away from the GTO 4 having a large heat generation rate so as to prevent the temperature of the diodes 2a, 8 from increasing. However, providing the diodes 2a, 8 away from the GTO 4 decreases space efficiency and increases the size of the inverter device, which hinders the downsizing demanded in the field of the invention. Moreover, the length of interconnections connecting each element is prolonged, which makes the increase of inductance by the interconnections unavoidable. When a time constant of the snubber circuit is increased by the increase of the inductance and thereby operation speed is lowered, functions of the snubber circuit are degraded.

### DISCLOSURE OF THE INVENTION

A power semiconductor device of the present invention includes at least one switching section for switching current from a power supply on and off, an inductor connected to between the switching section and the power supply, and a wide-gap semiconductor diode element using a wide-gap semiconductor connected to the inductor in parallel so as to be opposed to the direction of a current flow.

According to the invention, a parallel connection which is composed of the inductor and the wide-gap semiconductor diode element and which is connected to between the switching section and the power supply functions as a series snubber circuit. When the switching section is turned on, the current rise is slowed down by the inductor of the series snubber circuit, which brings about an effect of protecting the switching section.

When the switching section is turned off, current by electromagnetic energy stored in the inductor flows to the wide-gap semiconductor diode element for circulation, where the current changes to heat and disappears. Although the temperature of the wide-gap semiconductor diode element rises, the wide-gap semiconductor diode element can operate at temperature considerably higher than normal temperature, and therefore a cooling means is simplified or made unnecessary. The wide-gap semiconductor diode element can be used with higher ON resistance than that of, for example, silicon diodes. For example, in a snubber circuit using a silicon diode, a resistance needs to be connected to the silicon diode in series, whereas in the present invention, the function of the resistance is fulfilled by the wide-gap semiconductor diode element.

A power semiconductor device in another aspect of the present invention includes at least one switching section for switching current from a power supply on and off, an inductor connected to between the switching section and the power supply, and a series connection which is composed of a wide-gap semiconductor diode element using a wide-gap semiconductor and a resistance and which is connected to the inductor in parallel so as to be opposed to the direction of a current flow.

According to the invention, the inductor connected to between the switching section and the power supply and the series connection which is composed of the resistance and the wide-gap semiconductor diode element and which is connected to the inductor in parallel functions as a series snubber circuit. When the switching section is turned on, the current rise is slowed down by the inductor of the series snubber circuit, which brings about an effect of protecting the switching section.

When the switching section is turned off, current by electromagnetic energy stored in the inductor flows into the resistance through the wide-gap semiconductor diode element, so that the current changes to heat in the wide-gap semiconductor diode element and in the resistance and disappears. Although the temperature of the wide-gap semiconductor diode element rises, the wide-gap semiconductor diode element can operate at temperature considerably higher than normal temperature, and therefore a cooling means is simplified or made unnecessary. The wide-gap semiconductor diode element during high temperature operation has higher ON resistance than that of, for example, silicon diodes. With the high ON resistance, electricity derived from the electromagnetic energy stored in the inductor changes to heat. In the present invention, the function of the resistance is fulfilled by the wide-gap semiconductor diode element, and therefore a resistance value can be decreased.

When the switching section is turned off, a voltage is generated between terminals of the anode reactor, and so displacement current flows to a diode for circulation of electromagnetic energy in the anode reactor. The current is superimposed on the current flowing through the anode reactor, so that a rate of rise of current in the switching section increases. However, by using a wide-gap semiconductor diode as the diode, a chip area can be made smaller than that in the case of Si diodes and thereby electrostatic capacity is decreased, so that the displacement current can be decreased and the rate of rise of current in the switching section can be decreased. Consequently, it becomes possible to delay the reverse recovery time of a free wheeling diode in the other switching section, so that the rate of rise of voltage in the switching section can also be decreased.

A power semiconductor device in still another aspect of the present invention includes an inductor with one end connected to one terminal of a power supply, and a series connection which is composed of a first wide-gap semiconductor diode in backward direction of an output current from the power supply and a resistance and which is connected in parallel with the inductor. One end of a first switching circuit is connected to the other end of the inductor, while one end of a second switching circuit is connected to the other end of the first switching circuit. The other end of the second switching circuit is connected to the other terminal of the power supply. A clamp capacitor is connected to between a connection point between the resistance and the first wide-gap semiconductor diode element and the other end of the power supply. A first snubber capacitor is connected to between the connection point between the resistance and the first wide-gap semiconductor diode element and a connection point between the first and second switching circuits. A series connection composed of a second snubber capacitor and a second wide-gap semiconductor diode in forward direction is connected to between the connection point between the first and second switching circuits and the other terminal of the power supply.

According to the invention, in addition to the above functions and effects, the first snubber capacitor suppresses over voltage applied to the first switching circuit when the first switching circuit is turned off. The second snubber capacitor suppresses over voltage applied to the second switching circuit when the second switching circuit is turned off.

A power semiconductor device in yet another aspect of the present invention includes at least one inductor connected to one terminal of a power supply, and a series connection which is composed of a first wide-gap semiconductor diode in backward direction of an output current from the power supply and a resistance and which is connected to each inductor in parallel. A first switching circuit is connected to each inductor in series. A second switching circuit is connected to each first switching circuit in series. A second inductor is connected to between each second switching circuit and the other terminal of the power supply. A series connection composed of a second wide-gap semiconductor diode in backward direction and a second resistance is connected to the second inductor in parallel. Moreover, a capacitor is connected to between a connection point between the first resistance and the first wide-gap semiconductor diode and a connection point between the second resistance and the second wide-gap semiconductor diode.

According to the invention, a series snubber circuit is each provided in between the first switching circuit and the power supply and in between the second switching circuit and the power supply. As a result, the first and second switching circuits are less likely to suffer unbalanced operations. This brings about an effect to stabilize the operation of the circuit.

According to the present invention, a diode made of a wide-gap semiconductor is used as a reflux diode for circulating current by electromagnetic energy from an anode reactor in a series snubber circuit. Since the wide-gap semiconductor diode can be used at temperature considerably higher than normal temperature, it becomes possible to downsize a heat sink for cooling. In some cases, the heat sink is made unnecessary and thereby the snubber circuit is downsized, which in turns makes it possible to downsize the power semiconductor device.

Structuring the reflux diode so as to function also as a diode of a parallel snubber circuit provided in the switching circuit reduces the number of component parts of the switching circuit, and thereby leads to downsizing and increased reliability of the power semiconductor device.

Using a wide-gap semiconductor diode as a reflux diode makes it possible to decrease a chip area and to thereby decrease its electrostatic capacity. Consequently, it becomes possible for the reflux diode to decrease displacement current when the switching section is turned on and to decrease a rate of rise of current in the switching section. Further, a rate of rise of voltage in the other switching section can be decreased.

By structuring a switching element and a free wheeling diode from a wide-gap semiconductor, the switching element and the free wheeling diode are incorporated in a single package and operated at temperature higher than normal temperature. Consequently, the cooling means such as heat sinks is made unnecessary or downsized, which makes it possible to simplify the structure of the power semiconductor device and allows downsizing, as well as to achieve the power semiconductor device operable in the environment of high temperature.

### BRIEF DESCRIPTION OF THE DRAWINGS

FIG. 1 is a circuit diagram showing a three-phase inverter device as a first embodiment of a power semiconductor device in the present invention;
FIG. 2 is a circuit diagram showing a switching circuit of only one phase in the three-phase inverter device as a second embodiment of the power semiconductor device in the present invention;
FIG. 3 is a circuit diagram showing a switching circuit of only one phase in the three-phase inverter device as a third embodiment of the power semiconductor device in the present invention;
FIG. 4 is a circuit diagram showing a switching circuit of only one phase in the three-phase inverter device as a fourth embodiment of the power semiconductor device in the present invention;
FIG. 5 is a circuit diagram showing a switching circuit of only one phase in the three-phase inverter device as a fifth embodiment of the power semiconductor device in the present invention;
FIG. 6 is a cross sectional view showing a SiC Schottky diode for use in the three-phase inverter device as a sixth embodiment of the power semiconductor device in the present invention; and
FIG. 7 is a circuit diagram showing a conventional inverter device.

### Reference Numerals:

- 20a: positive terminal
- 20b: negative terminal
- 31a, 31b, 31c: anode reactor
- 32a, 32b, 32c: SiC-pn diode
- 33a, 33b, 33c: resistance
- 34a, 34b, 34c: GTO
- 35a, 35b, 35c: free wheeling diode
- 36a, 36b, 36c: SiC-GTO
- 37a, 37b, 37c: free wheeling diode
- 38a: clamp capacitor
- 40a, 41a: snubber capacitor
- 45a: resistance
- 46a: SiC diode
- 54a, 54b, 54c: series snubber circuit
- 55a, 55b, 55c: first switching circuit
- 56a, 56b, 56c: second switching circuit
- 57a, 57b, 57c: connection point
- 64a: series snubber circuit
- 65a: first switching circuit
- 66a: second switching circuit
- 74a: snubber circuit
- 76a: second switching circuit
- 80: SiC Schottky diode
- 84: cathode electrode
- 85: anode electrode

### DETAILED DESCRIPTION OF THE INVENTION

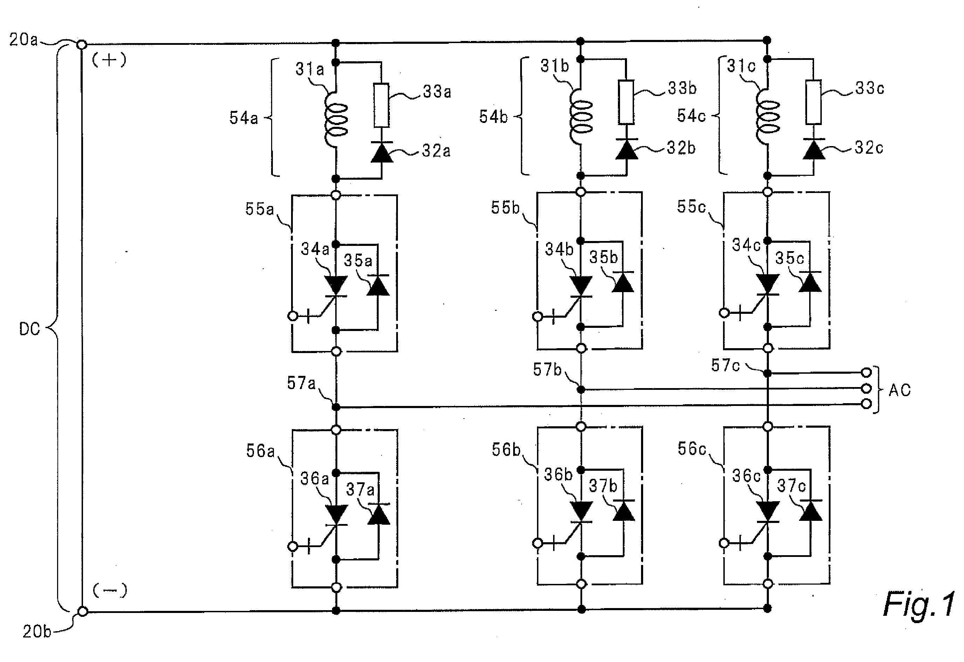

Preferred embodiments of a power semiconductor device in the invention will now be described with reference to Fig. 1 to Fig. 6.

### (First Embodiment)

A three-phase inverter device, that is a power semiconductor device in the first embodiment of the present invention, will be described with reference to Fig. 1. In the drawing, a series connection formed by connecting a series snubber circuit 54a, a first switching circuit 55a and a second switching circuit 56a in this order is connected to between a positive terminal 20a and a negative terminal 20b of a direct current input DC (direct current power supply). Similarly, a series connection composed of a series snubber circuit 54b, a first switching circuit 55b and a second switching circuit 56b is connected to between the positive terminal 20a and the negative terminal 20b. A series connection composed of a series snubber circuit 54c, a first switching circuit 55c and a second switching circuit 56c is connected to between the positive terminal 20a and the negative terminal 20b. The series snubber circuit 54a, and the first and second switching circuits 55a, 56a should not necessarily be connected to between the positive terminal 20a and the negative terminal 20b in this order but may be connected in arbitrary order. This also applies to other circuits including the series snubber circuits 54b, 54c, the first switching circuits 55b, 55c, and the second switching circuits 56b, 56c.

The first switching circuit 55a is structured from an antiparallel connection composed of a GTO 34a made of a Si or SiC semiconductor serving as a switching element and a free wheeling diode 35a made of a Si or SiC semiconductor. The first and second switching circuits 55b, 55c, 56a to 56c share the same structure with the first switching circuit 55a. Each of the first switching circuits 55a to 55c and the second switching circuits 56a to 56c is controlled by a control signal applied to each GTO gate from a known control circuit which is not shown in the drawing. An alternate current output AC can be obtained from a connection point 57a between the first switching circuit 55a and the second switching circuit 56a, a connection point 57b between the first switching circuit 55b and the second switching circuit 56b, and a connection point 57c between the first switching circuit 55c and the second switching circuit 56c. The circuit shown in Fig. 1 can also operate as a converter by inputting an alternate current into the terminal of the alternate current output AC. In this case, the positive terminal 20a and the negative terminal 20b of the direct current input DC can obtain a direct current output. This operation is achieved in the same manner in second embodiment to fifth embodiment.

Since the series snubber circuits 54a, 54b, 54c have the same structure and the same operation, detailed description will now be given of the series snubber circuit 54a on behalf of these circuits. Also, since the first switching circuits 55a to 55c and the second switching circuits 56a to 56c have the same structure and the same operation, detailed description will now be given of the first switching circuit 55a (hereinbelow simply referred to as a switching circuit 55a) on behalf of these circuits.

The series snubber circuit 54a has an anode reactor 31a including an inductor such as coils and a series connection which is composed of a SiC-pn diode 32a and a resistance (reflux resistance) 33a and which is connected to the anode reactor 31a in parallel. The SiC-pn diode 32a is a wide-gap semiconductor pn diode (hereinbelow abbreviated to SiC diode 32a) with use of silicon carbide (SiC) that is a wide-gap semiconductor. Examples of the wide-gap semiconductor include gallium nitride (GaN) and diamond, though in this embodiment, description will be given of an example using SiC. One terminal of the anode reactor 31a is connected to the positive terminal 20a, while the other terminal is connected to the switching circuit 55a.

When the GTO 34a in the switching circuit 55a is turned on, current from the direct current input DC flows to the GTO 34a through the anode reactor 31a. The anode reactor 31a slackens the rise characteristics of the current flowing into the GTO 34a.

When the GTO 34a is turned off, current by electromagnetic energy stored in the anode reactor 31a flows through the SiC diode 32a and the resistance 33a, where the current is turned into heat and consumed.

The SiC diode 32a for use in the series snubber circuit 54a in the present embodiment has characteristics described below.

The SiC diode 32a operates normally in the junction temperature from 150 °C to 500 °C due to high-temperature resistance characteristics of SiC. In the present embodiment, in the state in which the inverter device shown in Fig. 1 operates while outputting a desired steady alternate current (hereinbelow referred to as the steady operation state), the density of current flowing through the SiC diode 32a in the series snubber circuit 54a is set higher than that in the case of rated operation. More specifically, the current density of the SiC diode 32a is set to be 5 times or 30 times larger than the current density when the junction temperature is normal temperature (100 °C or below). The higher the current density is set, the more the junction temperature of the SiC diode 32a rises. In concrete, the SiC diode to be employed should have such a junction area that the temperature of the junction becomes approx. 150 °C during steady operation. In other words, the SiC diode 32a having much smaller capacity and smaller junction area, i.e., smaller rated capacity, is sufficient for use than those operated at normal temperature, i.e., under usual rated operation.

An experiment by an inventor of the present invention proved that the junction temperature became approx. 250 °C if the current density was set approx. 20 times to 30 times larger than the current density at the rated operation. This rate changes depending on the heat radiation characteristics and the heat resistance of a heat sink mounted on the SiC diode 32a.

As a result of increasing the current density of the SiC diode 32a, its junction temperature rises and its ON resistance increases. The increase in the ON resistance in turn increases ON voltage, which is, for example, in the range of 3 V to 20 V. With the increase in the ON resistance, electricity due to the electromagnetic energy stored in the anode reactor 31a is also consumed by the ON resistance of the SiC diode 32a. Therefore, the electricity which should be consumed by the resistance 33a is partially consumed by the SiC diode 32a. As a result, it becomes possible to use, as the resistance 33a, a resistance having a smaller resistance value and a rated capacity than those of the resistance 3a in the series snubber circuit 14a of the conventional inverter device shown in Fig. 7. Further, with the presence of the SiC diode, electrostatic capacity is decreased and thereby displacement current of the SiC diode can be decreased, so that the rate of rise of current when the switching section is turned on can be reduced.

The SiC diode 32a has a shift time from the off state to on state (on time) shorter than that of Si diodes and the like. This makes it possible to pass quickly the current from the anode reactor 31a to the resistance 33a when the GTO 34a is turned off. Consequently, voltage generated between both the terminals of the anode reactor 31a during the turned-off time is low. An experiment confirmed that the voltage was approx. 40 % of the voltage of the series snubber circuit 14a using the Si diode 2a shown in Fig. 7.

The SiC diode 32a of the series snubber circuit 54a may be replaced with a SiC Schottky diode with high withstand voltage. The ON resistance of the SiC Schottky diode is higher than that of the SiC-pn diode at high temperature. Because of this, the ON voltage of the SiC Schottky diode is also high; the ON voltage of the SiC Schottky diode for use in the present embodiment is approx. 30 V at approx. 250 °C. Replacing the SiC diode 32a with such a SiC Schottky diode with high ON resistance makes it possible to omit the resistance 33a. Since the resistance 33a is generally equipped with a heat sink, omitting the resistance 33a makes the heat sink unnecessary and have a profound effect on reduction in component parts and space, thereby contributing to downsizing of the inverter device.

In a concrete example in the present embodiment, in the condition that the voltage of the direct current input DC was 1000 V and that the current passing the GTO 34a was 50 A, the over voltage generated in the GTO 34a when the GTO 34a blocked the current of 50 A was approx 40 V. In the structure in which the Si diode 2a is used in the series snubber circuit 14a as seen in the conventional example shown in Fig. 7, over voltage when a current of 50 A with a direct current voltage of 1000 V is blocked in the same condition is approx. 380 V. Therefore, the over voltage in the present embodiment is about 1/10 of the over voltage in the conventional example.

In the switching circuit 55a of the present embodiment shown in Fig. 1, the GTO 34a and the free wheeling diode 35a are incorporated in a single package shown by a chain line so as to shorten connection lead wires between the GTO 34a and the free wheeling diode 35a. The shortened lead wires make it possible to reduce inductance and enable the inverter device to support high frequencies. Moreover, incorporating the GTO 34a and the free wheeling diode 35a in a single package reduces the number of component parts compared to the case of assembling separate component parts, and this increases reliability and reduces the total cost as well as allows downsizing.

It is also possible to structure so that the SiC diode 32a in the series snubber circuit 54a is also incorporated in the package (unshown). In this structure, a SiC-GTO is used as the GTO 34a serving as a switching element and a SiC diode is used as the free wheeling diode 35a. More specifically, forming all the semiconductor elements by SiC semiconductors and incorporating them in a single package enable all the SiC semiconductor elements in the package to operate at temperature as high as 250 °C. This makes it possible to simplify a cooling device such as heat sinks in the package for achieving simple structure as well as to implement considerable downsizing.

Although in the series snubber circuit 54a in the present embodiment, a series connection composed of the SiC diode 32a and the resistance 33a is connected to the anode reactor 31a in parallel, the same effects as those of the present embodiment can also be achieved by another structure, in which a series connection composed of the SiC diode 32a and a power regenerative circuit is connected to the anode reactor 31a in parallel. The power regenerative circuit is to collect and make efficient use of electric energy which is changed to heat and consumed in the resistance 33a.

In the present embodiment shown in Fig. 1, the same effects can also be achieved if the series snubber circuit 54a is connected to between the first switching circuit 55a and the second switching circuit 56a.

### (Second Embodiment)

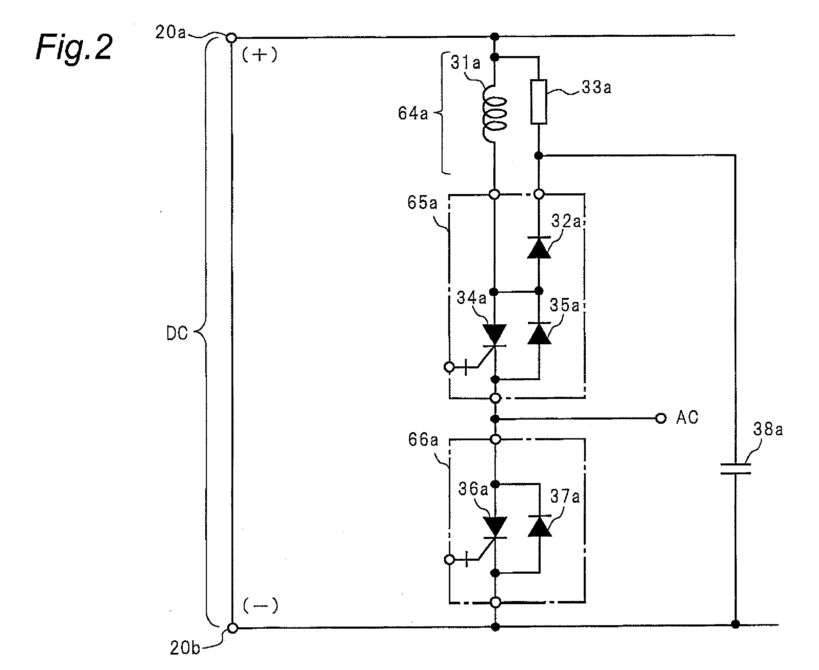

Description is now given of a three-phase inverter device that is a power semiconductor device in a second embodiment of the present invention with reference to Fig. 2. Fig. 2 is a circuit diagram showing a switching circuit of one phase in the three-phase inverter device in the second embodiment of the present invention. In the drawing, a series connection composed of a snubber circuit 64a, a first switching circuit 65a and a second switching circuit 66a is connected to between a positive terminal 20a and a negative terminal 20b of a direct input DC (direct current power supply). While the actual three-phase inverter device is composed of three series connections of three phases which share the same structure and the same operation and which are connected to between the positive terminal 20a and the negative terminal 20b, only one phase is shown in the drawing and illustration and description of other two phases are omitted for simplification. While the three-phase inverter device in the present embodiment is controlled by a known control circuit whose illustration is omitted, the first switching circuit 65a and the second switching circuit 66a are turned on with different timing and are not turned on at the same time.

In Fig. 2, a series snubber circuit 64a has an anode reactor 31a and a series connection which is composed of a SiC diode 32a serving as a reflux diode and a resistance 33a and which is connected to the anode reactor 31a in parallel. A clamp capacitor 38a is connected to between a connection point between the SiC diode 32a and the resistance 33a and the negative terminal 20b. In the present embodiment, the SiC diode 32a in the series snubber circuit 64a is incorporated in the package of the first switching circuit 65a. The switching elements constituting the first and second switching circuits 65a and 66a are a SiC-GTO 34a and a SiC-GTO 36a, which are GTOs with use of SiC semiconductors. By forming the switching elements from SiC-GTOs 34a, 36a with use of wide gap semiconductor SiCs, the switching speed becomes not less than 10 times higher than that of the Si-GTO. A free wheeling diode 35a and a free wheeling diode 37a serve as free wheeling diodes. In the second switching circuit 66a, the SiC-GTO 36a and the free wheeling diode 37a are also incorporated in a single package.

In the present embodiment, the clamp capacitor 38a is connected to between the connection point between the SiC diode 32a and the resistance 33a and the negative terminal 20b, so that the SiC diode 32a functions also as a clamp diode when an over voltage higher than the voltage of the direct current input DC is applied to a series body composed of the first and second switching circuits 65a and 66a. The SiC diode 32a functioning as a clamp diode makes it unnecessary to separately provide a clamp diode. This simplifies a circuit including the first switching circuit 65a and the series snubber circuit 64a and thereby makes it possible to shorten interconnections. As a result, the inductance of the interconnections is decreased, and therefore when the SiC-GTO 34a is turned off, over voltage applied to the anode and the cathode can be lowered. Therefore, it becomes possible to prevent the SiC-GTO 34a from being damaged by the over voltage.

During operation of the inverter device shown in Fig. 2, when the SiC-GTO 34a as a switching element in the first switching circuit 65a is turned off, over voltage is generated by electomagnetic energy stored in the anode reactor 31a and the inductance of the interconnections. In order to suppress the over voltage, current by the over voltage is sent to the clamp capacitor 38a, by which the clamp capacitor 38a is charged. This makes it possible to prevent the over voltage from being applied to the SiC-GTO 34a. Excess electricity charged to the clamp capacitor 38a is passed to and consumed by the resistance 33a. Since the SiC diode 32a is used as a reflux diode of the series snubber circuit 64a, it becomes possible to pass the current flowing the anode reactor 31a to the reflux resistance 33a through the SiC diode 32a at high speed when the SiC-GTO 34a is turned off. Consequently, it becomes possible to prevent the over voltage by electomagnetic energy in the anode reactor 31a from being applied to the SiC-GTO 34a. Moreover, since the electricity by electomagnetic energy in the anode reactor 31a is consumed by large ON resistance of the SiC diode 32a, the electricity can be damped at higher speed than that in the case where the electricity is consumed only by the resistance 33a. The high-speed operation of the SiC diode 32a can increase the drive frequency of the inverter device.

Moreover, since the low electrostatic capacity of the SiC diode can suppress a rate of rise of current in the switching section, a rate of rise of the voltage applied to the other switching section can also be suppressed.

In the present embodiment as with the first embodiment, the SiC diode 32a in the series snubber circuit 64a can operate at temperature as high as approx. 250 °C. The SiC-GTO 34a and the free wheeling diode 35a incorporated in the same package as the SiC diode 32a are also operated with high current density and therefore reach generally the same temperature as the SiC diode 32a. Operating the SiC diode 32a with high current density makes it possible to achieve the functions and effects identical to those described in the first embodiment. Since the second switching circuit 66a can also be operated at high temperature like the first switching circuit 65a, heat sinks and the like of the first and second switching circuits 65a and 66a are made unnecessary or downsized, by which downsizing of the entire inverter device can be achieved. Incorporating the first and second switching circuits 65a and 66a in respective packages can reduce the number of component parts and enhance reliability, which in turn allows reduction in size and cost of the inverter device.

Increasing the current density increases the ON resistance of the SiC diode 32a in the series snubber circuit 64a, and therefore it also becomes possible to remove the resistance 33a by substituting the ON resistance of the SiC diode 32a for the resistance 33a. In this case, the clamp capacitor 38a is connected to between the connection point between the SiC diode 32a and the free wheeling diode 35a and the negative terminal 20b. This allows further downsizing.

Since incorporating the first and second switching circuits 65a and 66a in respective packages shortens the length of connecting conductors for connecting each element, the inductance of the connecting conductors decreases. The decrease in the inductance can suppress the generation of over voltage attributed to the inductance and can increase the drive frequency of the inverter device.

### (Third Embodiment)

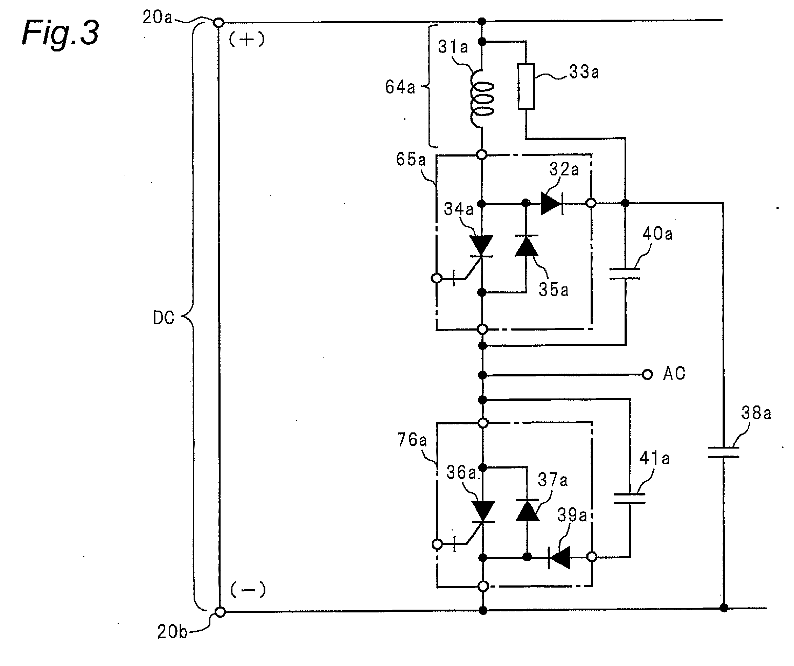

Description is now given of a three-phase inverter device that is a power semiconductor device in a third embodiment of the present invention with reference to Fig. 3. Fig. 3 is a circuit diagram showing a switching circuit of one phase in the three-phase inverter device, and the circuits of other two phases are omitted. In Fig. 3, a series snubber circuit 64a composed of an anode reactor 31a, a SiC diode 32a and a resistance 33a is similar to that in the second embodiment shown in Fig. 2.

A first switching circuit 65a has a SiC-GTO 34a and a SiC free wheeling diode 35a connected in antiparallel, and the SiC-GTO 34a and the SiC diodes 32a, 35a are incorporated in a single package. A clamp capacitor 38a is connected to between the cathode of the SiC diode 32a and the negative terminal 20b, while a snubber capacitor 40a is connected to between the cathode of the SiC diode 32a and the cathode of the SiC-GTO 34a. The SiC diode 32a and the snubber capacitor 40a constitute a parallel snubber circuit in the first switching circuit 65a. Therefore, the SiC diode 32a functions as an element for both the series snubber circuit 64a and the parallel snubber circuit.

The second switching circuit 76a has a SiC-GTO 36a, a free wheeling diode 37a connected to the SiC-GTO 36a in antiparallel, and a series connection which is composed of a snubber capacitor 41a and a SiC diode 39a and which is connected to the anode and the cathode of the SiC-GTO 36a. The SiC diode 39a and the snubber capacitor 41a constitute a parallel snubber circuit in the second snubber circuit 76a.

In the present embodiment as with the second embodiment, the SiC diodes 32a, 35a and the SiC-GTO 34a can be operated at temperature as high as approx. 250 °C. The SiC-GTO 36a and the SiC diodes 37a, 39a in the second snubber circuit 76a can also be operated at normal temperature or be operated at temperature as high as approx. 250 °C.

In the three-phase inverter device in the present embodiment, the SiC diode 32a and the snubber capacitor 40a make it possible to hold down the over voltage applied to the SiC-GTO 34a when the SiC-GTO 34a is turned off. Also, the SiC diode 39a and the snubber capacitor 41a make it possible to hold down the over voltage applied to the SiC-GTO 36a when the SiC-GTO 36a is turned off. The energy stored in the snubber capacitor 40a by absorbing the over voltage is partially consumed by the resistance 33a in the series snubber circuit 64a, while the remaining energy returns to the power supply.

In the present embodiment, the SiC diode 32a for circulating the electomagnetic energy of the anode reactor 31a in the snubber circuit 64a also serves as a component of a parallel snubber circuit structured in combination with the snubber capacitor 40a. This decreases the number of component parts. Since each of the first and second switching circuit 65a and 76a can also be operated at temperature as high as 250 °C or higher in the present embodiment, the heat sinks can be downsized. This allows downsizing of the inverter device. Moreover, the presence of the parallel snubber circuit having the snubber capacitors 40a, 41a allows effective suppression of large over voltage generated when the first and second switching circuits 65a and 76a using the SiC-GTOs 34a, 36a, which have far shorter switching time than Si-GTOs as switching elements, are turned off.

### (Fourth Embodiment)

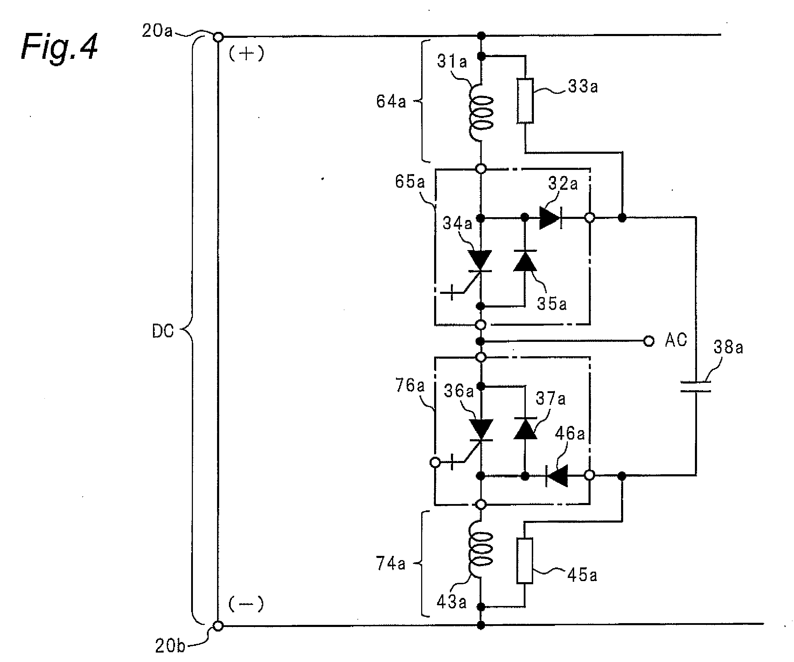

Fig. 4 is a circuit diagram showing one phase of a three-phase inverter device that is a power semiconductor device in a fourth embodiment of the present invention. As the circuits of other two phases are identical to the circuit of the one phase, their illustration is omitted.

In Fig. 4, a series snubber circuit 64a, and first and second switching circuits 65a and 76a are identical to those in the third embodiment shown in Fig. 3.

In the present embodiment, another anode reactor 43a is connected to between the cathode of a SiC-GTO 36a in the second snubber circuit 76a and the negative terminal 20b of the direct current input DC. Also, another resistance 45a is connected to between the anode of a SiC diode 46a and the negative terminal 20b. A clamp capacitor 38a is connected to between the cathode of a SiC diode 32a in the series snubber circuit 64a and the anode of the SiC diode 46a.

In the present embodiment, the SiC-GTO 34a, a free wheeling diode 35a and the SiC diode 32a are incorporated in the package of the first switching circuit 65a. The second switching circuit 76a is also incorporated in another package. The SiC-GTOs 34a, 36a and the SiC diodes 32a, 35a, 37a, 46a are operated at temperature higher than normal temperature, e.g., at approx. 250 °C. This allows downsizing of the heat sinks and contributes to downsizing of the inverter device.

During operation of the inverter device in the present embodiment, the over voltage, which is applied to the SiC-GTO 34a and the free wheeling diode 35a at the time of recovery of the SiC diode 32a and the free wheeling diode 35a when the SiC-GTO 34a is turned off, is suppressed by the clamp capacitor 38a. The over voltage, which is applied to the SiC-GTO 36a and the free wheeling diode 37a at the time of recovery of the free wheeling diode 37a and the SiC diode 46a when the SiC-GTO 36a is turned off, is suppressed by the clamp capacitor 38a. If the inductance of the anode reactors 31a, 43a is set at a specified value, a rate of rise of the voltage applied to the SiC-GTO 34a or 36a at the time of recovery of the free wheeling diode 35a or 37a can be controlled so as to be lower than a critical rate of rise of off-state voltage of the SiC-GTOs 34a, 36a. This can prevent false firing of the SiC-GTO 34a or 36a and can thereby prevent the SiC-GTOs 34a, 36a from suffering failures by the false firing.

In the inverter device in the present embodiment, the anode reactor 31a is provided in between the first switching circuit 65a and the positive terminal 20a, and the anode reactor 43a is provided in between the second snubber circuit 76a and the negative terminal 20b, so that unbalance in over voltage and difference in rate of rise of voltage between upper and lower arms of the inverter circuit can be decreased.

### (Fifth Embodiment)

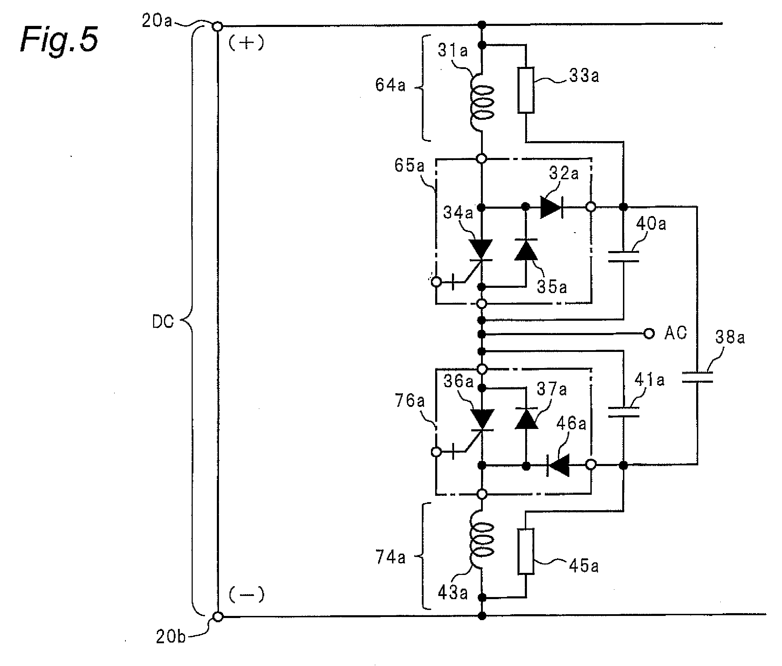

Fig. 5 is a circuit diagram showing one phase of a three-phase inverter device that is a power semiconductor device in a fifth embodiment of the present invention, and the circuits of other two phases are omitted.

The circuit shown in Fig. 5 is structured based on the circuit of the fourth embodiment shown in Fig. 4, in which the snubber capacitor 40a is connected to between the cathode of the SiC diode 32a and the cathode of the SiC-GTO 34a and the snubber capacitor 41a is connected in between the anode of the SiC diode 46a and the anode of the SiC-GTO 36a. Other structural aspects are identical to those shown in Fig. 4.

During operation of the inverter device in the present embodiment, the over voltage generated when the SiC-GTO 34a or the SiC-GTO 36a is turned off is reduced by charging of the snubber capacitor 40a or 41a. The steep voltage rise generated at the time of recovery of the free wheeling diode 35a or 37a is also suppressed by charging of the snubber capacitor 40a or 41a. As a result, it becomes possible to prevent false firing of the SiC-GTOs 34a, 36a and to prevent the SiC-GTO 34a or 36a from being damaged or suffering failures due to the false firing.

In the present embodiment, the SiC-GTO 34a, the SiC diode 32a and the free wheeling diode 35a are also incorporated in a single package. The SiC-GTO 36a, the SiC diode 46a and the free wheeling diode 37a are also incorporated in a single package. Since all the semiconductor elements in each package are made of wide-gap semiconductor SiCs, they can be used at temperature higher than normal temperature, e.g., at approx. 250 °C. Therefore, the cooling means such as heat sinks can be simplified or can be omitted in some cases. Since the SiC-GTO 34a, the SiC diode 32a and the free wheeling diode 35a are incorporated in a single package, and the SiC-GTO 36a, the SiC diode 46a and the free wheeling diode 37a are also incorporated in a single package, the connecting conductors between the elements in each package can be shortened. This can enhance the frequency characteristics in the first and second switching circuits 65a and 76a and achieve downsizing.

Moreover, incorporating the SiC-GTO 34a, the SiC diode 32a and the free wheeling diode 35a in a single package makes the temperature of these three elements almost identical, which brings about an effect of making their characteristics almost identical during operation. This effect is also true for the elements in the second switching circuit 76a.

### (Sixth Embodiment)

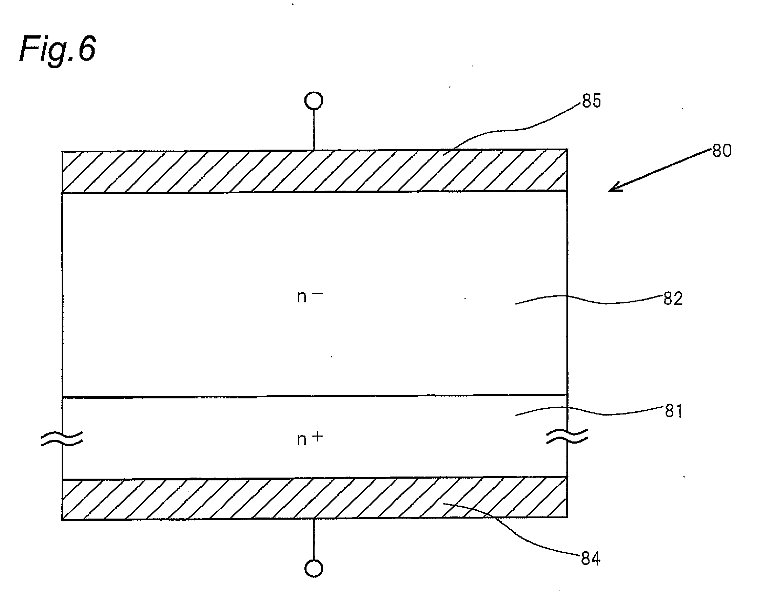

Fig. 6 is a cross sectional view showing a SiC Schottky diode for use in a series snubber circuit for a three-phase inverter device that is a power semiconductor device in a sixth embodiment of the present invention. The SiC Schottky diode in the present embodiment can be used in place of the SiC diodes 32a, 39a and 46a in the three-phase inverter devices in the first to the fifth embodiments shown in Fig. 1 to Fig. 5.

In Fig. 6, a drift layer 82 made of a lightly-doped (n-) n-SiC semiconductor containing nitrogen as dopant and having a thickness of 50 to 100 µm is formed on a substrate 81 made of a heavily-doped (n+) n-type 4H-SiC semiconductor having a thickness of 300 µm. The dopant concentration of the drift layer 82 should preferably be in the range of 1×10¹³ to 5×10¹⁴cm⁻³. A cathode electrode 84 made of nickel (Ni), gold (Au) or the like is provided on the lower surface of the substrate 81, while an anode electrode 85 made of nickel is provided on the upper surface of the drift layer 82.

Generally, SiC semiconductor diodes gain higher ON resistance if the thickness of their drift layer is increased and the dopant concentration is lowered. In the present embodiment, the ON resistance is increased by increasing the thickness of the drift layer 82 of a SiC Schottky diode 80. The ON resistance is also increased by lowering the dopant concentration. In the Sic Schottky diode 80 in the present embodiment, the thickness of the drift layer 82 is approx. 100 µm. The drift layer 82 is set to have a thickness 1.5 times larger than the thickness necessary for withstanding the backward voltage applied to the SiC Schottky diode 80. Consequently, the ON resistance becomes 1.5 times larger than that of SiC Schottky diodes manufactured by the standard design criteria. The ON resistance of SiC-pn diodes is also increased by increasing the thickness of their drift layer and lowering the dopant concentration. Higher temperature increases the ON resistance of SiC-pn diodes but not to the level of the SiC Schottky diodes.

The SiC Schottky diode 80 in the present embodiment is used in place of, for example, the SiC diode 32a in Fig. 1. Since the ON resistance of the SiC Schottky diode 80 increases electricity consumption in the element, the SiC Schottky diode 80 generates heat and raises temperature. Since the SiC Schottky diode 80 has higher ON resistance than the SiC-pn diode at high temperature, the SiC Schottky diode 80 can take over the role of the resistance 33a. In some cases, the resistance 33a can be omitted.

Although SiC-GTOs are used as switching elements in the first to the fifth embodiments, other wide-gap semiconductor GTOs such as gallium nitride (GaN) and diamond other than SiC can also be used, and in such a case, the same functions and effects can be achieved. Moreover, although the GTOs used in each embodiment are structured to have a gate on the cathode side, GTOs having a gate on the anode side (unshown) can also be used while the same functions and effects can be achieved.

### INDUSTRIAL APPLICABILITY

The present invention is applicable to small-size power semiconductor devices with high withstand voltage.

## Claims

1. A snubber circuit, comprising:
an inductor; and
a wide gap semiconductor diode element using a wide gap semiconductor connected to the inductor in parallel.

2. A snubber circuit, comprising:
an inductor; and
a series connection which is composed of a wide gap semiconductor diode element using a wide gap semiconductor and a resistance and which is connected to the inductor in parallel.

3. A snubber circuit, comprising:
an inductor; and
a series connection which is composed of a wide gap semiconductor diode element using a wide gap semiconductor and a power regenerative circuit and which is connected to the inductor in parallel.

4. A power semiconductor device, comprising;
at least one switching section for turning current from a power supply on and off;
an inductor connected to the switching section in series; and
a wide gap semiconductor diode element using a wide gap semiconductor connected to the inductor in parallel.

5. A power semiconductor device, comprising;
at least one switching section for turning current from a power supply on and off;
an inductor connected to the switching section in series; and
a series connection which is composed of a wide gap semiconductor diode element using a wide gap semiconductor and a resistance and which is connected to the inductor in parallel.

6. A power semiconductor device, comprising;
a first switching section for turning current on and off;
a second switching section connected to the first switching section in series;
an inductor connected to the first or the second switching section in series; and
a series connection which is composed of a wide gap semiconductor diode element using a wide gap semiconductor and a resistance and which is connected to the inductor in parallel.

7. A power semiconductor device, comprising;
a first switching section for turning current on and off;
a second switching section connected to the first switching section in series;
a first inductor connected to the first switching section in series;
a series connection which is composed of a wide gap semiconductor diode element using a wide gap semiconductor and a resistance and which is connected to the first inductor in parallel;
a second inductor connected to the second switching section in series; and
a series connection which is composed of a wide gap semiconductor diode element using a wide gap semiconductor and a resistance and which is connected to the second inductor in parallel.

8. The power semiconductor device according to Claim 4,
wherein the switching section has a semiconductor switching element connected in floe direction of the current and a free wheeling diode connected to the switching element in antiparallel.

9. The power semiconductor device according to Claim 4,
wherein in the wide gap semiconductor diode element, current density of a junction is so set that temperature of the junction during operation is higher than normal temperature.

10. The power semiconductor device according to Claim 4,
wherein in the wide gap semiconductor diode element, current density of a junction is so set that temperature of the junction during operation is 150 °C or higher.

11. The power semiconductor device according to Claim 4,
wherein the switching section has a wide gap semiconductor diode element using a wide gap semiconductor and a wide gap semiconductor free wheeling diode using a wide gap semiconductor which is connected to the wide gap semiconductor switching element in antiparallel, and
wherein the wide gap semiconductor switching element, the wide gap semiconductor free wheeling diode and the wide gap semiconductor diode element are provided in a single package.

12. The power semiconductor device according to Claim 6,
wherein a capacitor is connected to between a connection point between one end of a resistance with the other end being connected to one terminal of the power supply and the wide gap semiconductor diode element and the other end of the power supply.

13. A power semiconductor device, comprising:
an inductor with one end connected to one terminal of a power supply;
a series connection composed of a first wide gap semiconductor diode in backward direction of an output current from the power supply and a resistance and which is connected to the inductor in parallel;
a first switching circuit with one end connected to the other end of the inductor;
a second switching circuit with one end connected to the other end of the first switching circuit while the other end connected to the other terminal of the power supply;
a clamp capacitor connected to between a connection point between the resistance and the first wide gap semiconductor diode element and the other end of the second switching circuit;
a first snubber capacitor connected to between the connection point between the resistance and the first wide gap semiconductor diode element and a connection point between the first and the second switching circuits; and
a series connection which is composed of a second snubber capacitor and a second wide gap semiconductor diode in forward direction and which is connected to between the connection point between the first and the second switching circuits and the other end of the second switching circuit.

14. A power semiconductor device, comprising:
at least one inductor connected to one terminal of a power supply;
a series connection which is composed of a first wide gap semiconductor diode in backward direction of an output current from the power supply and a resistance and which is connected to each inductor in parallel;
a first switching circuit connected to each inductor in series;
a second switching circuit connected to each first switching circuit in series;
a second inductor connected to between each second switching circuit and the other terminal of the power supply;
a series connection which is composed of a second wide gap semiconductor diode in backward direction and a second resistance and which is connected to the second inductor in parallel; and
a capacitor connected to a connection point between the first resistance and the first wide gap semiconductor diode and a connection point between the second resistance and the second wide gap semiconductor diode.

15. The power semiconductor device according to Claim 14, further comprising:
a second capacitor connected to between the connection point between the first resistance and the first wide gap semiconductor diode and a connection point between the first switching circuit and the second switching circuit; and
a third capacitor connected to between the connection point between the second resistance and the second wide gap semiconductor diode and the connection point between the first switching circuit and the second switching circuit.

16. The power semiconductor device according to Claim 14,
wherein the first and the second switching circuits respectively have a semiconductor switching element connected in flow direction of the current and a free wheeling diode connected to the switching element in antiparallel.

17. The power semiconductor device according to Claim 14,
wherein in the first and the second wide gap semiconductor diode elements, current density of a junction is so set that temperature of the junction during operation is higher than normal temperature.

18. The power semiconductor device according to Claim 14,
wherein in the first and the second wide gap semiconductor diode elements, current density of a junction is so set that temperature of the junction during operation is 150 °C or higher.

19. The power semiconductor device according to Claim 16,
wherein the first and the second switching circuits respectively have a wide gap semiconductor diode element using a wide gap semiconductor and a wide gap semiconductor free wheeling diode using a wide gap semiconductor which is connected to the wide gap semiconductor switching element in antiparallel, and
wherein the wide gap semiconductor switching element, the wide gap semiconductor free wheeling diode and the wide gap semiconductor diode element are provided in a single package.

20. The power semiconductor device according to Claim 4,
wherein the wide gap semiconductor diode element is a wide gap semiconductor Schottky diode.

21. The power semiconductor device according to Claim 4,
wherein a drift layer of the wide gap semiconductor diode element has a thickness larger than a thickness corresponding to a desired reverse breakdown voltage of the wide gap semiconductor diode element.

22. The power semiconductor device according to Claim 4,
wherein a drift layer of the wide gap semiconductor diode element has a low dopant concentration.

23. A power semiconductor device, comprising:
at least one snubber circuit having an inductor and a series connection which is composed of a first wide gap semiconductor diode and a resistance and which is connected to the inductor in parallel;
a first switching circuit connected to the snubber circuit in series; and
a second switching circuit connected to either the first switching circuit or the snubber circuit in series.
